Europäisches Patentamt

European Patent Office

Office européen des brevets

(19)

(11) Publication number: **0 115 950**
A2

# EUROPEAN PATENT APPLICATION

(12)

(21) Application number: **84300537.2**

(22) Date of filing: **27.01.84**

(51) Int. Cl.³: **H 01 L 35/16**

(30) Priority: **31.01.83 US 462512**

(43) Date of publication of application: **15.08.84**
**Bulletin 84/33**

(84) Designated Contracting States: **BE DE FR GB IT NL**

(71) Applicant: **ENERGY CONVERSION DEVICES, INC.,**
**1675 West Maple Road, Troy Michigan 48084 (US)**

(72) Inventor: **Manteghi, Kamran, 4241 Ranwick Court, San**
**José California 95178 (US)**
Inventor: **Allred, David Dean, 3980 North Adams, Troy**
**Missouri 48084 (US)**

(74) Representative: **Jackson, Peter Arthur, GILL JENNINGS**
**& EVERY 53-64 Chancery Lane, London WC2A 1HN (GB)**

(54) New powder pressed N-type thermoelectric materials and method of making same.

(57) The disclosure relates to new and improved compacted or pressed powder materials for thermoelectric applications. The materials have commercially high figures of merit in desired temperature ranges. Also disclosed is a method for making the materials. The materials include lead telluride and a modifying element which is capable of forming solid phase alloys with tellurium but incapable of forming solid phase alloys with lead. The materials are multiphase materials having at least three phases including lead telluride, a telluride of the modifying element, and the modifying element. The modifying element preferably is manganese forming, during processing, lead telluride, manganese telluride, and manganese phases. The modifying element can also be aluminium, chromium, or titanium.

The materials are made in accordance with the general method of the present invention by forming a particulate mixture containing lead telluride and the modifying element. At least a portion of the particulate mixture is then compressed to form a compacted body of the material. Lastly, the compacted body of material is sintered at a temperature between 400°C and 700°C in a forming gas atmosphere and then cooled to room temperature.

-1-

NEW POWDER PRESSED N-TYPE THERMOELECTRIC
MATERIALS AND METHOD OF MAKING SAME

The present invention relates to new and improved powder pressed materials for thermoelectric applications and a method for making the same.

It has been recognized that the world supply of fossil fuels for the production of energy is being exhausted at ever increasing rates. This realization has resulted in an energy crisis which impacts not only the world's economy, but threatens the peace and stability of the world. The solution to the energy crisis lies in the development of new fuels and more efficient techniques to utilize them. To that end, the present invention deals with energy conservation, power generation, pollution, and the generation of new business opportunities by the development of new materials for use in devices which provide more electricity.

An important part of the solution with respect to the development of permanent, economical energy conversion lies in the field of thermoelectrics wherein electrical power is generated by heat. It has been estimated that two-thirds of all our energy, for example, from automobile exhausts or power plants, is wasted and given off to the environment. Up until now, there has been no serious climatic effect from this thermal pollution. However, it has been predicted that as the world's energy consumption increases, the effects of thermal pollution will ultimately lead to a

-2-

partial melting of the polar ice caps with an attendant increase in sea level. Employment of the waste heat for the regeneration of electricity can provide a direct reduction in the thermal pollution, independent of the source of the energy.

The performance of a thermoelectric device can be expressed in terms of a figure of merit (Z) for the material forming the device, wherein Z is defined as:

$$Z = \frac{S^2\sigma}{K}$$

where: Z is expressed in units x $10^3$

S is the Seebeck coefficient in $\mu V/°C$

K is the thermal conductivity in mW/cm-°K

$\sigma$ is the electrical conductivity in $(\Omega-cm)^{-1}$

From the above, one can see that in order for a material to be suitable for thermoelectric power conversion, it must have a large value for the thermoelectric power Seebeck coefficient (S), a high electrical conductivity ($\sigma$), and a low thermal conductivity (K). Further, there are two components to the thermal conductivity (K): $K\ell$, the lattice component; and $K_e$, the electrical component. In non-metals, $K\ell$ dominates and it is this component which mainly determines the value of K.

-3-

Stated in another way, in order for a material to be efficient for thermoelectric power conversion, it is important to allow carriers to diffuse easily from the hot junction to the cold junction while maintaining the temperature gradient. Hence, high electrical conductivity is required along with low thermal conductivity.

Thermoelectric power conversion has not found wide usage in the past. The major reason for this is that prior art thermoelectric materials which are at all suitable for commercial applications have been crystalline in structure. Those crystalline materials best suited for thermoelectric devices are very difficult to manufacture because of poor mechanical properties and sensitivity of material properties to compositional changes. This results because they contain a predominance of elements, such as tellurium, and selenium which are natural glass formers. The growth, control, and mechanical stability of these crystals have, therefore, led to what to this date are insurmountable problems. In particular, the materials having a high figure of merit (Z) are generally made from chalcogenides such as tellurium compounds which are notorious for the difficulties in growth of high quality single crystals. Even when such crystals are grown, they contain large densities of defects and are often unstable. In addition, they usually are far from stoichiometric. For all of these reasons, controlled doping has proven to be extremely difficult.

Crystalline solids cannot attain large values of electrical conductivity while maintaining low thermal conductivity. Most importantly, because of crystalline symmetry, thermal conductivity cannot be controlled by modification.

In the case of the conventional polycrystalline approach, the problems of single crystalline materials still dominate. However, new problems are also encountered by virtue of the polycrystalline grain boundaries which cause these materials to have relatively low electrical conductivities. In addition, the fabrication of these materials is also difficult to control as a result of their more complex crystalline structure. The chemical modification or doping of these materials, because of the above problems, is especially difficult.

Among the best known currently existing polycrystalline thermoelectric materials are $(Bi, Sb)_2Te_3$, PbTe, and Si-Ge. The $(Bi, Sb)_2Te_3$ represents a continuous solid solution system in which the relative amounts of Bi and Sb are 0 to 100%. The Si-Ge materials are best suited for high temperature applications in the 600° to 1000°C range with a satisfactory Z appearing at above 700°C. The PbTe polycrystalline material exhibits its best figure of merit in the 300° to 500°C range. None of these materials is well suited for applications in the 100°C to 300°C range. This is indeed unfortunate, because it is in this temperature range where a wide variety of waste heat applications are found. Among such applications are geothermal waste heat and waste

-5-

heat from internal combustion or diesel engines in, for example, trucks, buses, and automobiles. Applications of this kind are important because the heat is truly waste heat. Heat in the higher temperature ranges must be intentionally generated with other fuels and therefore is not truly waste heat.

Improved thermoelectric materials have been developed which are not single phase crystalline materials, but instead, are disordered materials. These materials are multiphase materials having both amorphous and multiple crystalline phases. Materials of this type are good thermal insulators. They include grain boundaries of various transitional phases varying in composition from the composition of matrix crystallites to the composition of the various phases in the grain boundary regions. The grain boundaries are highly disordered with the transitional phases including phases of high thermal resistivity to provide high resistance to thermal conduction. Contrary to conventional materials these materials have grain boundaries defining regions including conductive phases therein providing numerous electrical conduction paths through the bulk material for increasing electrical conductivity without substantially effecting the thermal conductivity. In essence, the materials have all of the advantages of polycrystalline materials in desirably low thermal conductivities and crystalline bulk Seebeck properties. However, unlike the prior art polycrystalline materials, these disordered multiphase materials also have desirably high electrical conductivities. Hence, as disclosed in the aforementioned referenced application, the $S^2\sigma$ product for the figure of merit of these materials can be independently maximized with desirably low thermal conductivities for thermoelectric power generation.

Amorphous materials, representing the highest degree of disorder, have been made for thermoelectric applications. The materials and methods for making the same are fully disclosed and claimed, for example, in U.S. Patents 4,177,473, 4,177,474 and 4,178,415 which issued in the name of Stanford R. Ovshinsky. The materials disclosed in these patents are formed in a solid amorphous host matrix having structural configurations which have local rather than long-range order and electronic configurations which have an energy gap and an electrical activation energy. Added to the amorphous host matrix is a modifier material having orbitals which interact with the amorphous host matrix as well as themselves to form electronic states in the energy gap. This interaction substantially modifies the electronic configurations of the amorphous host matrix to substantially reduce the activation energy and hence, increase substantially the electrical conductivity of the material. The resulting electrical conductivity can be controlled by the amount of modifier material added to the host matrix. The amorphous host matrix is normally of intrinsic-like conduction and the modified material changes the same to extrinsic-like conduction.

As also disclosed therein, the amorphous host matrix can have lone pairs having orbitals wherein the orbitals of the modifier material interact therewith to form the new electronic states in the energy gap. In another form, the host matrix can have primarily tetrahedral bonding wherein the modifier material is added primarily in a non-substitutional manner with its orbitals interacting with the host matrix. Both d and f band materials as well as boron and carbon, which add multiorbital possibilities can be used as modifiers to form the new electronic states in the energy gap.

As a result of the foregoing, these amorphous thermoelectric materials have substantially increased electrical conductivity. However, because they remain amorphous after modification, they retain their low thermal conductivities making them well suited for thermoelectric applications, especially in high temperature ranges above 400°C.

These materials are modified on an atomic or microscopic level with the atomic configurations thereof substantially changed to provide the above-mentioned independently increased electrical conductivities. In contrast, the multiphasic materials discussed above are not atomically modified. Rather, they are fabricated in a manner which introduces disorder into the material on a macroscopic level. This disorder allows various phases including conductive phases to be introduced into the materials much in the same manner as modification atomically in pure amorphous phase materials to provide controlled high electrical conductivity while the disorder in the other phases provides low thermal conductivity. These materials therefore are intermediate in terms of their thermal conductivity between amorphous and regular polycrystalline materials.

One attempt at making two phase thermoelectric materials is disclosed in U.S. Patent No. 3,285,019. The materials disclosed in this patent were lead telluride based materials having incorporated therein other elements and which were processed in such a way so as to form strains in the material. As disclosed, it was believed that these strains would decrease the lattice thermal conductivity for increasing the figure of merit. The other elements, such as manganese, were introduced into the material in a manner which prevented or limited the dispersion of the added elements into the lead telluride or prevented or limited the chemical reactivity of the added elements with the lead telluride. In the case of the lead telluride based material incorporating manganese, the material was prepared by a hot extrusion process which limited the solubility of the manganese to less than ten percent. As a result, and as stated in the patent, a strained, two phase material resulted having decreased thermal conductivity.

-9-

The materials of the present invention are also lead telluride based materials. However, the materials of the present invention incorporate modifying elements with intended dispersion and reactivity for increasing the electrical conductivity of the material over the electrical conductivity of lead telluride at temperatures below about 300°C. Also, the materials of the present invention have more than two phases and include at least three phases. In addition to phase disorder, the materials of the present invention are in the form of compacted bodies of material formed from pressed lead telluride and modifying element particulate material resulting in additional disorder. During a firing step, the modifying element undergoes solid state reactions. The modifying element in pure or alloy form has a stronger affinity for tellurium and oxygen than lead does and doesn't form solid phase alloys or compounds with lead. The solid state reactions involving the modifying element during firing or sintering improve the material in several ways. Oxygen impurities which reduce electron mobility can be decreased and lead is released which dopes the material n-type and increases the electrical conductivity substantially. The intended dispersion and solid state reactivity of the modifying elements during sintering or firing of the compacted bodies results in the formation of the at least three phases. The three phase material has electrical conductivity greater than the electrical conductivity of unmodified lead telluride. Even though the thermal conductivity is increased and the Seebeck coefficient is decreased, the materials provide a figure of merit which is acceptable for commercial applications, especially in the temperature range up to about 300°C. In fact, the figure of merit of these materials is essentially as high as the figure of merit of the conventional prior art polycrystalline materials in this temperature range when such materials are very carefully grown.

In addition to the foregoing, the materials of the present invention can be compacted or pressed into solid form with dimensions suitable for direct application as thermoelectric elements for thermoelectric devices. Also, the elements can be formed at commercially acceptable high rates to sustain high volume mass production of thermoelectric devices. This is not possible with conventional polycrystalline materials which must be grown over long periods of time under precisely controlled growing conditions or with lead telluride materials formed by the extrusion process disclosed in the aforementioned Patent No. 3,285,019.

The present invention provides new and improved compacted or pressed powder materials for thermoelectric applications. The materials have commercially high figures of merit in desired temperature ranges. The present invention also provides a method for making the materials. The materials of the present invention include lead telluride and a modifying element which is capable of forming solid phase alloys with tellurium but incapable of forming solid phase alloys with lead. The materials of the present invention are multiphase materials having at least three phases including lead telluride, a telluride of the modifying element, and the modifying element. The modifying element preferably is manganese forming, during processing, lead telluride, manganese telluride, and manganese phases. The modifying element can also be aluminum, chromium, or titanium.

The materials are made in accordance with the general method of the present invention by forming a particulate mixture containing lead telluride and the modifying element. At least a portion of the particulate mixture is then compressed to form a compacted body of the material. Lastly, the compacted body of material is sintered at a temperature between 400°C and 700°C in a forming gas atmosphere and then cooled to room temperature.

Accordingly, a first object of the invention is to provide a thermoelectric material characterized by a body formed from lead telluride and a modifying element, the modifying element being capable of forming solid phase alloys with tellurium but incapable of forming solid phase alloys with lead, the body including at least three phases including lead telluride, a telluride of the modifying element and the modifying element.

A second object of the invention is to provide a method of making a thermoelectric material characterized by: forming a particulate mixture

-12-

of about 99 to 95 weight percent lead telluride and 1 to 5 weight percent of a modifying element, the modifying element being capable of forming solid phase alloys with tellurium but incapable of forming solid phase alloys with lead; compressing at least a portion of the particulate mixture to form a compacted body of material; and thereafter sintering the compacted body of material to form the thermoelectric material.

The preferred embodiments of this invention will now be described by way of example, with reference to the drawings accompanying this specification in which:

Figure 1 is a graph illustrating the figure of merit (Z) versus temperature for an n-type material of the present invention made in accordance with a preferred embodiment of the method of the present invention;

Figure 2 is a graph illustrating electrical conductivity ($\sigma$) versus temperature for the alloy materials of Fig. 1;

Figure 3 is a graph illustrating the figure of merit (Z) versus temperature for various alloy materials of the present invention having the same composition but which were pressed at various pressures;

Figure 4 is a graph illustrating the electrical conductivity ($\sigma$) versus temperature for the alloy materials of Fig. 3 pressed at various pressures;

Figure 5 is a graph illustrating the figure of merit (Z) versus temperature for various alloy materials of the present invention having the same composition but which were formed from various particle sizes;

Figure 6 is a graph illustrating the electrical conductivity ($\sigma$) versus temperature for the alloy materials of Fig. 5 formed from various particle sizes; and

Figure 7 is a graph illustrating the electrical conductivity ($\sigma$) versus temperature for various alloy materials of the present invention having different compositions.

The present invention provides a method of making compacted or pressed powder thermoelectric materials having commercially high figures of merit (Z) over desired temperature ranges for many applications. The materials of the present invention, in many respects, have a structure similar to the disordered structure of the multiphasic materials discussed above. The materials of the present invention have phase disorder resulting from dispersion and solid state reactions wherein the elements combine in their different phases in an atomic manner. The materials also include macroscopic forms of disorder wherein the materials have compositional disorder, translational disorder, configurational disorder or other disorders such as transitional phases between the phases. The materials have increased electrical conductivity and acceptably low thermal conductivity. The materials of the present invention are formed from lead telluride and a modifying element which are combined to form at least three phases including the modifying element, a telluride of the modifying element and a matrix of lead telluride with a small amount of the modifying element inhomogeneously dispersed therein. The materials are highly electrically conductive compared to unmodified lead telluride due to the reaction of the modifying elements and phases throughout the bulk of the material which affords control of the electrical conductivity whereas typical crystalline structures have overall bulk conductivity properties not easily changed. The materials of the present invention, while having increased electrical conductivity compared to unmodified lead telluride, also have acceptably low thermal conductivity.

Disorder in thermoelectric materials can be of varying degrees. Single phase crystalline materials, of course, can afford little disorder and therefore have substantially fixed parameters. Pure amorphous materials have no long range order at all and can be modified in a manner as previously described. The materials of the present invention when made in accordance with the method of the present invention, are multiphase in structure having substantially more disorder than the crystalline materials of the prior art and have varying degrees of order and disorder inherent in them. The disorder may be the result of compositional disorder wherein a structure becomes disordered by combining elements in a manner which randomly varies the elemental distributions in the material.

Translational and configurational disorder in the materials is evident because the grain boundaries between the phases are arranged at random. Also, the phases are of varying sizes and orientations while the grain boundaries are of corresponding, varying orientation. These disorders are evident because the phases are of varying shapes having random and irregular surface configurations. The grain boundaries also randomly vary in configuration.

All of the above result in materials which are very disordered accounting for acceptable low thermal conductivities while the modifying elements and phases provide high electrical conductivities. Even though the modifying elements and phases provide, in the entire volume of the materials greatly increased electrical conductivity, the thermal conductivity remains acceptably low. The pressed powder materials of the present invention do exhibit a decreased Seebeck coefficient. However, because of the greatly increased electrical conductivity and the acceptably low thermal conductivity the materials of the present invention maintain sufficiently high figures of merit to render them suitable for commercial applications.

Another important point is that stoichiometry and purity are not as critical for these materials as for conventional materials. Therefore, a much greater latitude for manufacturing and lifetime stability are possible. These materials are enhanced or unaffected by disorder unlike prior crystalline or polycrystalline materials.

-16-

Another advantage of disordered materials is that they are more flexible than crystalline materials. The disordered material is thus capable of more distortion during expansion and contraction allowing for greater mechanical stability during heating and cooling cycles of the material.

In general, and in accordance with the broader aspects of the present invention, the method of making the improved powder pressed thermoelectric materials of the invention is practiced by forming a particulate mixture containing lead telluride and a modifying element capable of forming solid phase alloys with tellurium but incapable of forming solid phase alloys with lead. Suitable elements for the modifying element are chromium, titanium, aluminum and manganese. Thereafter, at least a portion of the particulate mixture is compressed at a pressure between five and fifteen tons per square centimeter to form a compacted body of the material.

The compacted body is then sintered at a temperature between 400 and 700°C in a forming gas for between 1 and 100 hours. Lastly, after the compacted body is sintered, the material is cooled to room temperature. During the sintering step, a solid state reaction takes place which forms at least three different phases in the material. These phases are lead telluride, a telluride of the modifying element, and the modifying element. During the solid state reaction, the modifying element and the lead telluride interdiffuse. The modifying element displaces lead and combines with tellurium to make the modifying element telluride phase. The displaced lead and the modifying element dope the lead telluride and the amount of each in excess of the solubility limit forms a fourth phase which is believed to lie along grain boundaries promoting improved transport properties in the increase of mobility of electrons through the material. The presence of the lead also improves the mechanical properties of the powder pressed composite. The modifying element is also believed to increase the electron mobility of lead telluride by scavenging oxygen. Oxygen impurities in lead telluride are known to decrease carrier mobility.

The lead telluride and the modifying element are combined in the proportions of about 99 to 95 wt.% (92 to 66 mole percent) of the lead telluride to 1 to 5 wt.% (8 to 34 atomic percent) of the modifying element. As will be noted from the specific examples disclosed hereinafter, maximized thermoelectric material characteristics can be obtained over desired temperature ranges by varying the respective proportions of the lead telluride and the modifying element.

### Example 1

The material of Example 1 has the composition of:

$(PbTe)_{84} + Mn_{16}$ (97 wt.% PbTe and 3 wt.% Mn)

This material was prepared in accordance with the method of the present invention in the following manner. The lead telluride was ground and sifted through a 150 mesh screen. The manganese particles varied in size up to about 200 microns in dimension. The lead telluride and manganese powders were then combined by weight in the indicated proportions and thoroughly mixed in a rotary mixer for about twenty minutes to form a particulate mixture. The mixture was then placed in a die and compressed at a pressure of 15 tons per square centimeter for one minute. The compacted body of material thus formed was placed in a quartz tube. The interior of the tube was purged for five minutes with a forming gas mixture of 4% hydrogen and 96% argon (3% to 8% hydrogen and 27% to 92% argon or nitrogen can be used). After purging, the tube was heated to 400°C for twenty minutes to sinter the compacted material in the presence of the forming gas. After sintering, the sintered compacted material was removed from the tube and allowed to cool to room temperature in ambient air.

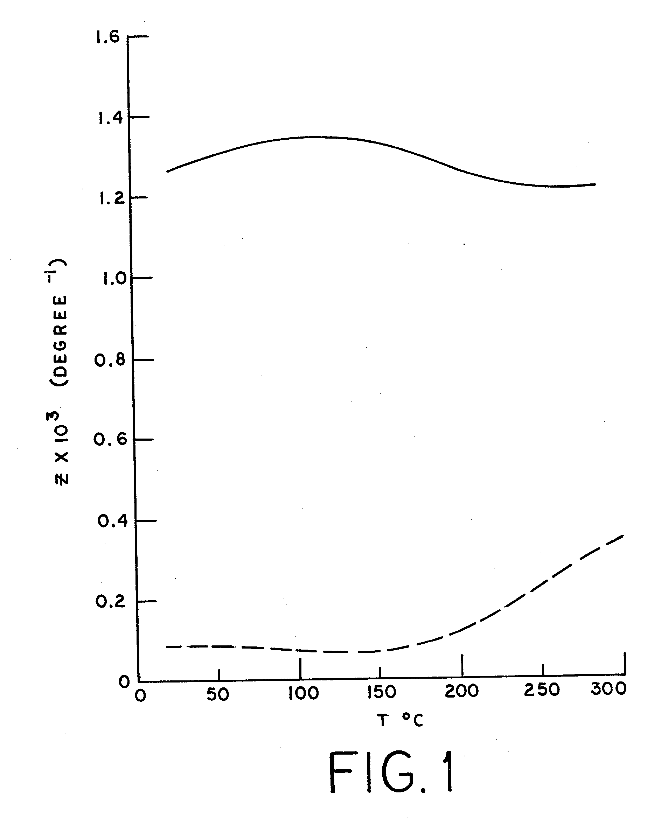

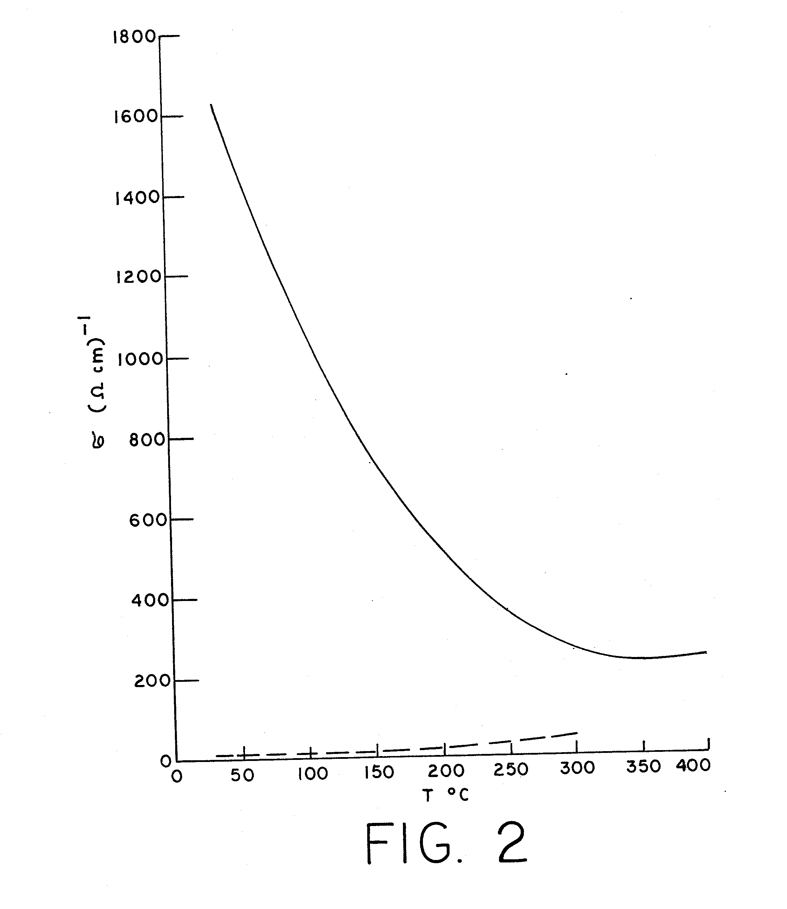

The room temperature Seebeck coefficient(s) for this material was about 160. Figs. 1 and 2 show the figure of merit (Z) and electrical conductivity ($\sigma$) versus temperature for the unmodified PbTe (dashed lines) and the PbTe material modified in accordance with this example (solid lines). Although the magnitude of the Seebeck coefficient is lower than the Seebeck coefficient of an unmodified lead telluride material, Figs. 1 and 2 illustrate that the figure of merit (Z) and electrical conductivity ($\sigma$) were substantially higher. Fig. 1 reveals that the figure of merit is substantially constant from room temperature to about 300°C. Fig. 2 reveals the substantially increased electrical conductivity which results when lead telluride is modified in accordance with the present invention.

### Examples 2-5

The materials of Examples 2-5 had the same composition as the material of Example 1 but were pressed or compacted under different pressures, $P_0$, $P_1$, $P_2$ and $P_3$ of 5, 10, 15, and 20 tons per square centimeter, respectively. The materials were otherwise prepared in accordance with the preferred embodiment described with respect to Example 1.

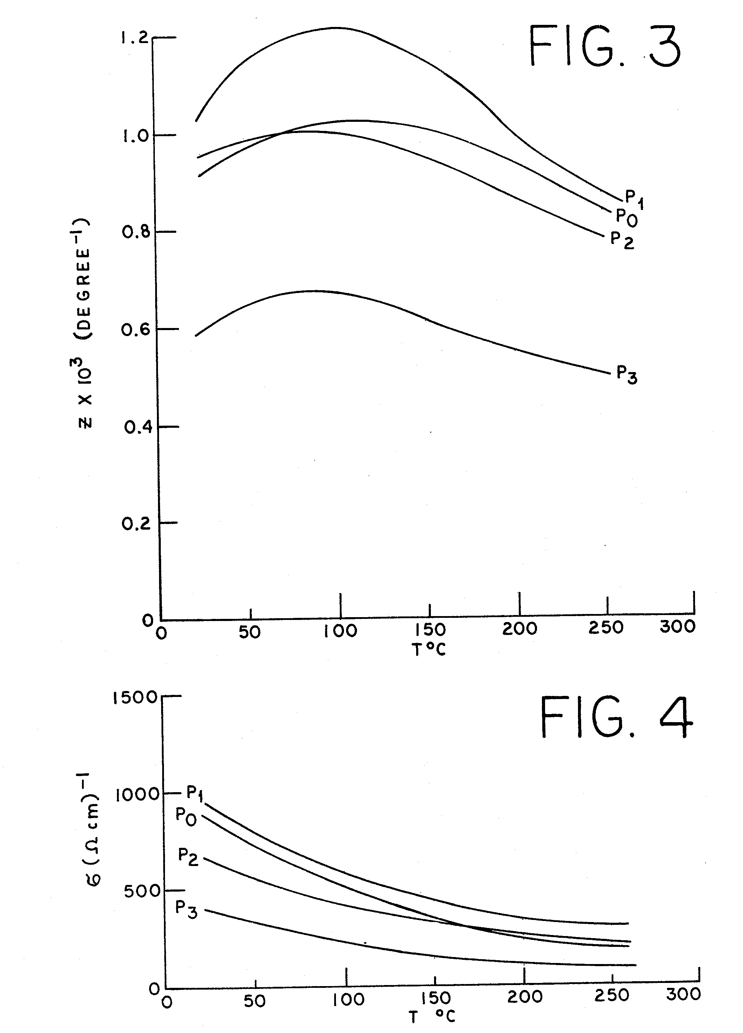

Figs. 3 and 4 illustrate the figure of merit (Z) and electrical conductivity ($\sigma$), respectively versus temperature for these materials. It can be noted from Figs. 3 and 4 that a pressing pressure of about 10 tons per square centimeter provides a material having a maximized figure of merit and electrical conductivity.

### Examples 6-11

These materials had the same composition and were prepared in the same manner as the material of Example 1. However, each of these materials was formed from manganese powder particles having sizes as follows: A, all sizes up to 200 µm; B, 75 to 98 µm; C, 53 to 75 µm; D, 45 to 53 µm; E, 38 to 45 µm; and F, less than 38 µm. They were all pressed under the same pressure of 15 tons per square centimeter.

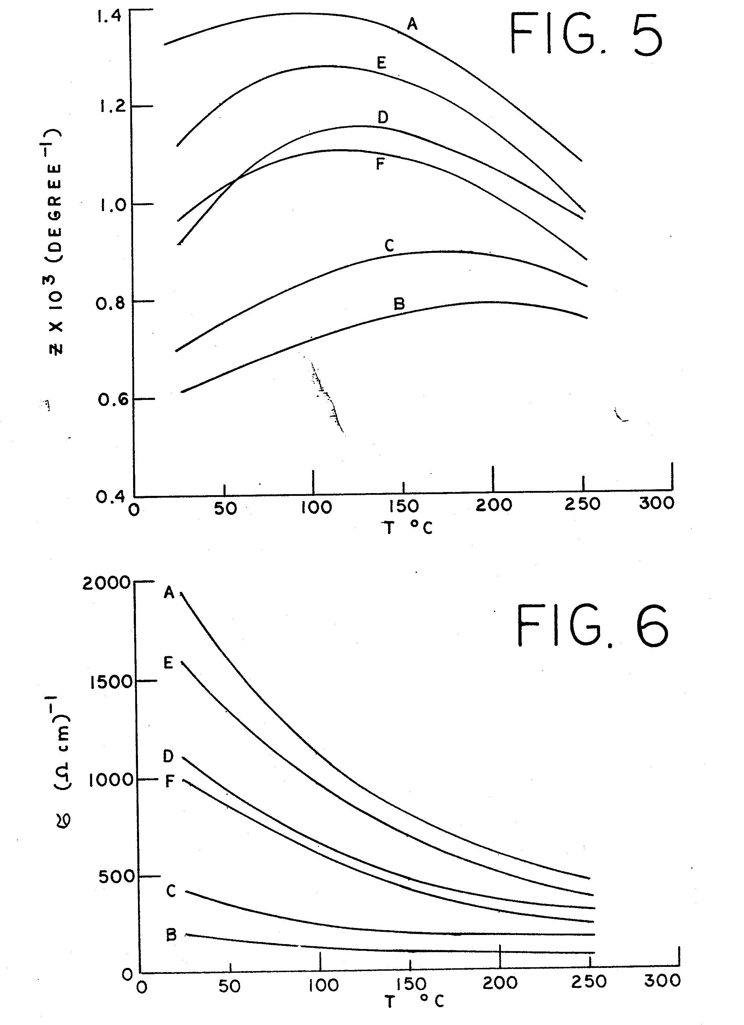

Figs. 5 and 6 illustrate the figure of merit (Z) and electrical conductivity ($\sigma$) respectively

-20-

versus temperature for these materials. It can be noted from Figs. 5 and 6 that there is a wide variance between particle size and the figure of merit and electrical conductivity of the resulting materials. The best figure of merit and electrical conductivity are obtained with material formed from manganese having particle sizes which include all sizes up to 200 μm. It is believed that varying particle sizes promote more thorough mixing of the lead telluride and manganese during the formation of the particulate mixture prior to pressing and as a result, more uniform dispersion of the manganese and the created phases during sintering.

By making reference to Fig. 1, it can be noted however, that the figure of merit of all of the materials of Examples 6-11 is greater than the figure of merit of the unmodified lead telluride material over the displayed temperature range. This is significant because most commercial applications are at temperatures above 200°C. Also, the difference is even more pronounced when considering the product of figure of merit and temperature (ZT) versus temperature. This is also significant because the product of ZT is directly proportional to the efficiency of a material in converting a temperature differential into electrical energy.

<u>Examples 12-13</u>

The materials of Examples 12-13 have the general composition of:

$$(PbTe)_{100-x}Mn_x$$

where x equals 8 or 34 corresponding to 1 and 5 wt. percent.

-21-

These materials were prepared in accordance with the preferred embodiment of the present invention as described with respect to Example 1.

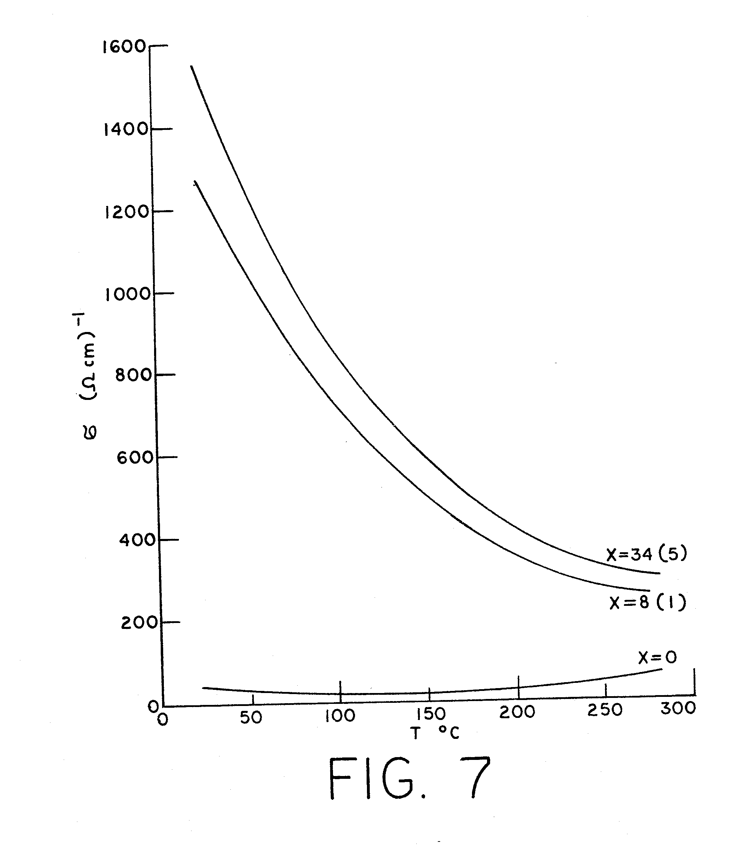

It can be noted from Fig. 7 that the material having about five weight percent manganese exhibits a better figure of merit than the material having about one weight percent manganese over the temperature range displayed. Reference to Fig. 1 will reveal that the material having three weight percent manganese has the best figure of merit. For each of these materials, the figure of merit is better than the conventional unmodified lead telluride material over the displayed temperature range.

Modifications and variations of the present invention are possible in light of the above teachings. While the examples herein are directed to PbTe material modified with manganese, in accordance with the present invention, PbTe modified with the other modifying elements aluminum, titanium, and chromium also exhibit increased figures of merit over unmodified PbTe when the other modifying elements are combined with PbTe in the same general proportions as disclosed in the preceding examples. It is therefore, to be understood that within the scope of the appended claims the invention may be practiced otherwise than as specifically described.

-22-

CLAIMS

1.  A thermoelectric material characterized by: a body formed from lead telluride and a modifying element, said modifying element being capable of forming solid phase alloys with tellurium but incapable of forming solid phase alloys with lead, said body including at least three phases including lead telluride, a telluride of said modifying element, and said modifying element.

2.  A material according to claim 1 further characterized by said body includes a fourth phase, said fourth phase being lead.

3.  A material according to any one of claims 1 or 2 further characterized by said modifying element is one of the group consisting of chromium, titanium, aluminum, and manganese.

4.  A material according to any one of claims 1 through 3 further characterized by said body comprises compressed particles of said lead telluride and said modifying element.

5.  A material according to claim 4 further characterized by said body includes between about one to five weight percent of said modifying element.

6.  A material according to claim 3 further characterized by said at least three phases are lead telluride, manganese telluride, and manganese.

7.  A method of making a thermoelectric material characterized by:

-23-

forming a particulate mixture of about ninety-nine to ninety-five weight percent lead telluride and one to five weight percent of a modifying element, said modifying element being capable of forming solid phase alloys with tellurium but incapable of forming solid phase alloys with lead;

compressing at least a portion of said particulate mixture to form a compacted body of material; and thereafter,

sintering said compacted body of material to form said thermoelectric material.

8. A method according to claim 7 further characterized by said particulate mixture includes about ninety-seven weight percent lead telluride and about three weight percent of said modifying element.

9. A method according to any one of claims 7 or 8 further characterized by said modifying element is selected from the group consisting of chromium, titanium, aluminum, and manganese.

10. A method according to any one of claims 7 through 9 further characterized by said particulate mixture is compressed at a pressure of five to twenty tons per square centimeter.

11. A method according to any one of claims 7 through 10 further characterized by said compacted body is sintered at a temperature between 400 and 700 degrees centigrade.

12. A method according to claim 7 further characterized by the modifying element particles of said particulate mixture vary in size up to about 200 micrometers in dimension.

-24-

13. A method according to any one of claims 11 or 12 further characterized by said compacted body is sintered for between one and one hundred hours.

14. A method according to any one of claims 11 through 13 further characterized by said compacted body is sintered for about twenty hours.

FIG.1

FIG. 2

FIG. 3

FIG. 4

0115950

FIG. 5

FIG. 6

FIG. 7